# EUROPÄISCHE PATENTANMELDUNG

(11) **EP 2 109 160 A1**
(43) Veröffentlichungstag der Anmeldung: **14.10.2009**
(21) Anmeldenummer: 08105872.9
(22) Anmeldetag: 26.11.2008
(51) Int. Cl.: H01L 41/053

(54) **Piezoaktormodul für eine von einem Medium umströmte Anordnung**

(30) Priorität: 11.04.2008 DE 102008018342
(71) Anmelder: Robert Bosch GmbH, 70442 Stuttgart (DE)
(72) Erfinder: Heinz, Rudolf, 71272 Renningen (DE); Junger, Dieter, 70374 Stuttgart (DE); Klotz, Claudia, 96047 Bamberg (DE); Schaich, Udo, 70378 Stuttgart (DE); Schlegl, Nicole, 73635 Rudersberg (DE); Haraguchi, Tatsuo, 96047 Bamberg (DE); Koellein, Robert, 96052 Bamberg (DE)

(57) **Zusammenfassung**

Es wird ein Piezoaktormodul (03) zur von einem Medium umströmten Anordnung beschrieben, bestehend aus einem Aktorfuß (05) und einem Aktorkopf (04) und mindestens einem dazwischen eingefassten Piezoaktor (16), umfassend ein mindestens den Piezoaktor (20) umgebendes Schutzschichtsystem (17) aus einer oder mehreren funktionellen Schichten, wobei das Schutzschichtsystem (17) mindestens:
- eine erste Schicht bestehend aus einer den mindestens einen Piezoaktor (16) umgebenden, an ihren beiden Enden mit dem Aktorfuß (05) und dem Aktorkopf (04) hochdruckdicht verbundenen Metallhülse (18, 24), sowie
- eine den durch Aktorfuß (05) und Aktorkopf (04) begrenzten Raum zwischen Metallhülse (18, 24) und dem mindestens einen Piezoaktor (16) vollständig ausfüllende zweite Schicht bestehend aus einem Elastomer und/oder einem elektrisch nichtleitenden Öl

aufweist.

## Beschreibung

### Stand der Technik

Die Erfindung betrifft ein Piezoaktormodul nach den gattungsgemäßen Merkmalen des Anspruchs 1.

Es ist an sich bekannt, dass zum Aufbau eines Piezoaktors für ein zuvor erwähntes Piezoaktormodul Piezoelemente so eingesetzt werden, dass unter Ausnutzung des sogenannten Piezoeffekts eine Steuerung des Nadelhubs eines Ventils oder dergleichen vorgenommen werden kann. Die Piezoelemente sind aus Piezolagen aus einem Material mit einer geeigneten Kristallstruktur so aufgebaut, dass bei Anlage einer äußeren elektrischen Spannung an Innenelektroden, die die Piezolagen jeweils einschließen, eine mechanische Reaktion der Piezoelemente erfolgt.

In Abhängigkeit von der Kristallstruktur und der Anlagebereiche der elektrischen Spannung stellt die mechanische Reaktion einen Druck oder Zug in eine vorgebbare Richtung dar. Derartige Piezoaktoren eignen sich beispielsweise für Anwendungen, bei denen Hubbewegungen unter hohen Betätigungskräften und hohen Taktfrequenzen ablaufen.

Piezoaktoren werden beispielsweise in Piezoinjektoren eingesetzt, welche zur zeitpunkt-und mengengenauen Dosierung von Kraftstoff in periodisch arbeitenden Verbrennungsmotoren verwendet werden.

Ein Piezoinjektor besteht im Wesentlichen aus einem Haltekörper und einem in dem Haltekörper angeordneten Piezoaktormodul, bestehend aus einem Kopf- und einem Fußteil sowie einem zwischen Kopf- und Fußteil angeordneten Piezoaktor aus einem oder mehreren Piezoelementen. Das Piezoaktormodul ist mit einer Düsennadel verbunden, sodass durch Anlegen oder Wegnahme einer Spannung an die Piezoelemente eine Düsenöffnung freigegeben oder verschlossen wird.

Bei der so genannten direkten Düsennadelsteuerung wird der Piezoaktor im Haltekörper des Piezoinjektors direkt im Kraftstoff unter Hochdruck betrieben. Zwischen Piezoaktor und Düsennadel sitzt dabei lediglich ein Koppler mit hydraulischer Übersetzung. Die Bewegung der Düsennadel folgt übersetzt direkt der Bewegung des Piezoaktors. Ein Piezoinjektor mit direkter Düsennadelsteuerung ist beispielsweise aus EP 117 46 15 A2 bekannt.

Zum Schutz des Piezoaktors bzw. der Piezoelemente vor Feuchtigkeit, etwa vor Diesel, Wasser, Raps-Methyl-Ester (RME) oder sonstigen elektrisch leitenden Substanzen, vor Partikeln und Schwebstoffen, vor den umgebenden hohen Drücken, sowie vor Druck- und Temperaturschwankungen ist es bekannt, den Piezoaktor in einem Piezoinjektor mit direkter Düsennadelsteuerung zumindest teilweise mit einer Schutzummantelung zu versehen.

Durch die WO 01/48834 A2 ist eine elektrische Isolation eines Piezoelements durch einen Schutzmantel aus Kunststoff bekannt, der beispielsweise durch Spritzgießen aufgebracht wird.

Aus der DE 102 17 361 A1 ist eine Lösung bekannt, bei der ein Piezoaktor an Teilen seiner Oberfläche zunächst mit einer organischen Basisschicht beschichtet ist. Diese ist wiederum mit einer anorganischen Deckschicht versehen, welche die Aufgabe hat, die Basisschicht gegenüber dem umgebenden Kraftstoff abzudichten, der ansonsten die organische Basisschicht angreifen würde. Dabei ist vorgesehen, dass das Material für die organische Basisschicht vorzugsweise aus Naturkautschuk, Isopren, Butadien oder einem fluorierten Material bestehen soll.

Durch die WO 02/61856 A1 ist ferner eine Lösung bekannt, bei der ein Piezoaktormodul, bestehend aus einem Piezoaktor, einem Aktorfuß und einem Aktorkopf, zunächst mit einem Schrumpfschlauch lose überzogen wird, im Folgenden der Zwischenraum zwischen Schrumpfschlauch und Piezoelement mit einem Füllmaterial gefüllt wird, und schließlich der Schrumpfschlauch durch Wärmeeinwirkung geschrumpft wird und dadurch Piezoaktor und Füllmaterial dicht einschließt.

Ebenso ist bekannt, einen Piezoaktor eines Piezoaktormoduls gegen das umgebende Medium abzudichten, indem der Piezoaktor in einer stabilen Metallhülse gekapselt wird. An einer auch als aktive Stirnfläche bezeichneten Stirnfläche des Piezoaktors liegt ein Aktorkopf auf, welcher Hub und Kraft des Piezoaktors nach außen überträgt. Dieser Aktorkopf ist über eine Membran mit der stabilen Hülse verbunden. Dabei schafft die Membran eine flexible, aber dichte Verbindung zwischen Aktorkopf und Hülse. Ein Teil des durch Aktorfuß und Aktorkopf begrenzten Raums zwischen Metallhülse und Piezoaktor wird von einer den Piezoaktor umhüllenden Elastomerschicht eingenommen. Das Beschichtungssystem ist dabei so aufgebaut, dass das Elastomer nicht den kompletten Raum ausfüllt und den restlichen Raum zur Wärmeausdehnung nutzen kann, ohne dabei die Metallhülse bzw. die Membran unzulässig in ihrer Festigkeit und Funktion zu belasten. Diese Lösung ist für Anwendungen geeignet, bei denen sich der Piezoaktor bzw. das Piezoaktormodul im Niederdruckbereich eines Piezoinjektors unter einem Umgebungsdruck von ca. 60 bar befindet. Soll der Piezoaktor dagegen im Hochdruckbereich eingebracht werden, wie eben bei der direkten Düsennadelsteuerung, so erreicht diese Lösung sowohl hinsichtlich der Festigkeit der Membran, als auch hinsichtlich der Festigkeit der stabilen Metallhülse ihre Grenzen. Insbesondere würde diese Lösung den bei der direkten Düsennadelsteuerung herrschenden, das Piezoaktormodul bzw. den Piezoaktor unmittelbar umgebenden hohen Systemdrücken sowie den bei der direkten Düsennadelsteuerung höheren Hubbewegungen des Piezoaktors unter den zur Verfügung stehenden Platzverhältnissen nicht standhalten.

### Offenbarung der Erfindung

Die Erfindung geht von einem eingangs beschriebenen Piezoaktormodul zur direkten Düsennadelsteuerung aus, bei einer von einem flüssigen und/oder gasförmigen Medium umströmten Anordnung, insbesondere in einem Piezoinjektor. Das Piezoaktormodul besteht aus einem Aktorfuß und einem Aktorkopf und dazwischen eingefassten elektrisch kontaktierbaren bzw. kontaktierten Piezoelementen als Piezoaktor. Es ist ein mindestens den Piezoaktor umgebendes Schutzschichtsystem aus einer oder mehreren funktionellen Schichten zur Verhinderung eines Eindringens des Mediums oder von Bestandteilen des Mediums in den Piezoaktor vorhanden.

Erfindungsgemäß weist das Schutzschichtsystem mindestens:
- eine erste Schicht bestehend aus einer den mindestens einen Piezoaktor umgebenden, an ihren beiden Enden mit dem Aktorfuß und dem Aktorkopf hochdruckdicht verbundenen Metallhülse, sowie
- eine den durch Aktorfuß und Aktorkopf begrenzten Raum zwischen Metallhülse und dem mindestens einen Piezoaktor vollständig ausfüllende zweite Schicht bestehend aus einem Elastomer und/oder einem elektrisch nichtleitenden Öl auf.

Da die Metallhülse ohne Lufteinschlüsse befüllt ist, werden Druckschwankungen im Piezoinjektor durch die Metallhülse so kompensiert, dass die Metallhülse jederzeit druckausgeglichen ist und sich auch bei radialer Verformung keine unzulässige Materialbelastung ergibt.

Das Elastomer dient dabei gleichzeitig zur Wärmeabfuhr von dem mindestens einen Piezoaktor zur Metallhülse, zur elektrischen Isolation und als Stützelement gegenüber der Metallhülse unter dem herrschenden, das Piezoaktormodul bzw. den Piezoaktor und die Metallhülse unmittelbar umgebenden Systemdruck von bis zu 2500 bar.

Vorteile der Erfindung gegenüber dem Stand der Technik ergeben sich unter anderem dadurch, dass durch das erfindungsgemäße Beschichtungssystem ein oder mehrere Piezoaktoren, welche sich im Inneren des Haltekörpers befinden, vor Feuchtigkeit, wie etwa Diesel, Wasser, RME und sonstigen leitenden Substanzen, vor Partikeln und Schwebstoffen, sowie vor den hohen Drücken, Druck- und Temperaturschwankungen geschützt werden.

Durch den erfindungsgemäßen Piezoaktor wird ein wirkungsvoller Schutz der Metallhülse vor Überbeanspruchung durch das Ausgleichen der Volumenänderungen des Elastomers und der benachbarten Bauteile, hervorgerufen durch Druck- und Temperatureinfluss, bei gleichzeitiger Gewährleistung der Hubbewegung des Piezoaktormoduls bzw. Piezoaktors erreicht. Ein wesentliches, mit der Erfindung erreichtes Ziel ist, dass die Metallhülse in ihrer Form und Geometrie keine unzulässige Belastung und undefinierte Verformung erfährt.

Die Erfindung erreicht einen kostengünstigen, einfachen und dauerhaften Schutz von insbesondere zur direkten Düsennadelsteuerung eingesetzten Piezoaktoren unter eingeschränkten Bauraumbedingungen bzw. Platzverhältnissen. Gleichzeitig werden unzulässige Belastungen und Verformungen der Metallhülse unterbunden, welche aus Druck, Temperatur und Volumenänderungen der von der Metallhülse umhüllten Bauteile bzw. der Bestandteile des Piezoaktormoduls hervorgehen. Zusätzlich werden die Belastungen auf den durch das erfindungsgemäße Schutzschichtsystem geschützten Piezoaktor bezüglich Kraft- und Hubverlust so klein wie möglich gehalten.

Ein weiterer Vorteil der Erfindung ergibt sich dadurch, dass keine beweglichen Teile, wie Kolben oder bewegliche Dichtelemente zum Einsatz kommen, welche im Vergleich zu Schweißverbindungen immer eine minimale Leckage und über höhere Laufzeiten Verschleiß an den Gleitflächen mit sich bringen.

Eine vorteilhafte Ausgestaltung der Erfindung sieht vor, dass die an beiden Enden mit Aktorfuß und Aktorkopf hochdruckdicht verbundene Metallhülse mit dem Aktorfuß und dem Aktorkopf hochdruckdicht verschweißt ist.

Vorzugsweise weist die Metallhülse eine in axialer Richtung wegausgleichende Geometrie auf. Dadurch nimmt die Metallhülse aus der Funktion des Piezoaktormoduls herrührende Hubbewegungen in axialer Richtung auf. Gleichzeitig wird über die Geometrie die Wärmedehnung des Elastomers und der anderen Bauteile ausgeglichen. Auf diese Weise wird eine zu hohe radiale Dehnung der bzw. mögliche Überbeanspruchung der Metallhülse verhindert.

Gemäß einer besonders vorteilhaften Ausgestaltung der Erfindung weist die Metallhülse eine Oberflächenstruktur auf, welche frei von plastischer Deformation dauerhaft eine gleichzeitige Verformung in axialer wie auch in radialer Richtung ermöglicht.

Vorzugsweise weist die Metallhülse eine Wabenstruktur auf. Die Metallhülse mit Wabenstruktur stellt den nötigen Hub- und Temperaturausgleich in einem Bereich von vorzugsweise mindestens - 40°C bis mindestens + 160°C am Piezoaktormodul bzw. Piezoaktor sicher. Dabei wird im Vergleich zum Stand der Technik die Permeation von Feuchtigkeit, wie etwa Diesel, Wasser, RME und sonstigen elektrisch leitenden Substanzen auf ein Minimum verringert bzw. unterbunden.

Eine besonders vorteilhafte Ausgestaltung der Erfindung sieht vor, dass die Metallhülse eine regelmäßige Wabenstruktur aufweist. Sie dient als flexibles Dicht- und Ausgleichelement und schützt den Piezoaktor vor Kraftstoff- und Wassereintritt. Eine regelmäßige Wabenstruktur ist leichter herzustellen, als eine unregelmäßige.

Eine zusätzliche, besonders vorteilhafte Ausgestaltung der Erfindung sieht vor, dass die Metallhülse eine sehr dünne Wandstärke aufweist. Die in ihrer Wandstärke sehr dünn gehaltene Metallhülse nimmt durch ihre konstruktive Auslegung mit einer Wabenstruktur die Hubbewegungen aus der Funktionsvorgabe auf. Gleichzeitig kann die vorzugsweise regelmäßige Wabenstruktur zumindest in einem begrenzten Maß auch beispielsweise sich aus der Wärmeausdehnung der von der Metallhülse umhüllten Bauteile ergebende Radialdehnungen aufnehmen.

Die Werkstoffpaarungen von Metallhülse, Aktorfuß und Aktorkopf sind vorzugsweise in Festigkeit und Wärmeausdehnungskoeffizienten so gewählt, dass keine zusätzlichen Temperaturbelastungen aus diesen Bauteilen aufaddiert werden.

Dabei ist es wichtig hervorzuheben, dass die Auslegung eines Schutzschichtsystems unter erfindungsgemäßer Integration von Temperaturausgleich und Funktionsbewegung einen erheblichen Gewinn an Bauraum nach sich zieht.

Kurze Beschreibung der Zeichnung

Ausführungsbeispiele der Erfindung werden im Folgenden näher beschrieben. Es zeigen:
- Fig. 1: eine schematische Darstellung eines Piezoinjektors in einem Längsschnitt.
- Fig. 2: eine schematische Darstellung eines ersten Ausführungsbeispiels einer Metallhülse mit unregelmäßiger Wabenstruktur in einer Draufsicht.
- Fig.3a bis 3c: schematische Darstellungen eines zweiten Ausführungsbeispiels einer Metallhülse mit regelmäßiger Wabenstruktur in einer in Fig.3a dargestellten Draufsicht in einem in Fig.3b dargestellten Querschnitt entlang der Linie A-B in Fig. 3a, sowie in einem in Fig.3c dargestellten Querschnitt entlang der Linie C-D in Fig.3a.
- Fig. 4a bis4c: schematische Darstellungen unterschiedlicher Wabenformen.
- Fig. 5: eine die Funktion der Wabenstruktur erklärende Prinzipdarstellung.

### Ausführungsformen der Erfindung

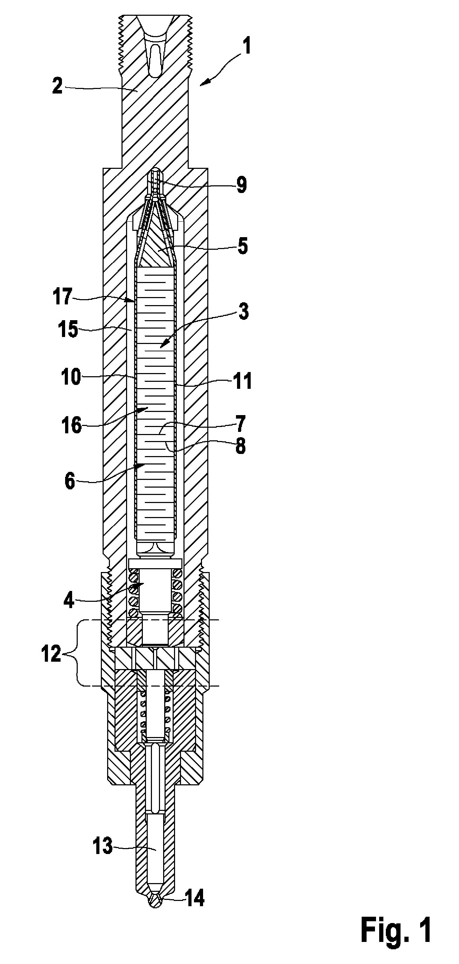

Ein in Fig. 1 dargestellter Piezoinjektor 01 mit direkter Düsennadelsteuerung umfasst im Wesentlichen einen Haltekörper 02 und ein in dem Haltekörper 02 angeordnetes Piezoaktormodul 03, das unter anderem einen Aktorkopf 04 und einen Aktorfuß 05, sowie mindestens einen zwischen dem Aktorkopf 04 und dem Aktorfuß 05 angeordneten, aus mehreren übereinander gestapelten Piezoelementen 06 bestehenden Piezoaktor 16 aufweist. Die Piezoelemente 06 bestehen jeweils aus Piezolagen aus Piezokeramik und diese einschließende Innenelektroden 07 und 08.

Die Innenelektroden 07 und 08 der Piezoelemente 06 sind mit Außenelektroden 10 und 11 und dann über ein Steckerteil 09 elektrisch kontaktiert. Das Piezoaktormodul 03 ist über einen Koppler 12 mit einer Düsennadel 13 verbunden. Durch Anlegen einer Spannung an die Piezoelemente 06 über die Innenelektroden 07 und 08 und die daraus folgende mechanische Reaktion wird, wie in der Beschreibungseinleitung erläutert, eine Düsenöffnung 14 freigegeben. Das Piezoaktormodul 03 wird bei der dargestellten Anwendung nach Fig. 1 als Piezoinjektor 01 in einem Raum 15 von einem mit dem Piezoinjektor 01 zu dosierenden Medium, typischerweise einem Kraftstoff für einen Verbrennungsmotor umströmt.

Der Piezoaktor 16 ist durch ein Schutzschichtsystem 17 vor dem Kraftstoff im Raum 15 bzw. vor schädlichen Bestandteilen des Kraftstoffs, wie etwa Wasser, RME oder sonstigen elektrisch leitenden Substanzen geschützt.

Das Schutzschichtsystem 17 besteht aus mehreren funktionellen Schichten zur Verhinderung eines Eindringens des Mediums oder von Bestandteilen des Mediums in den Piezoaktor.

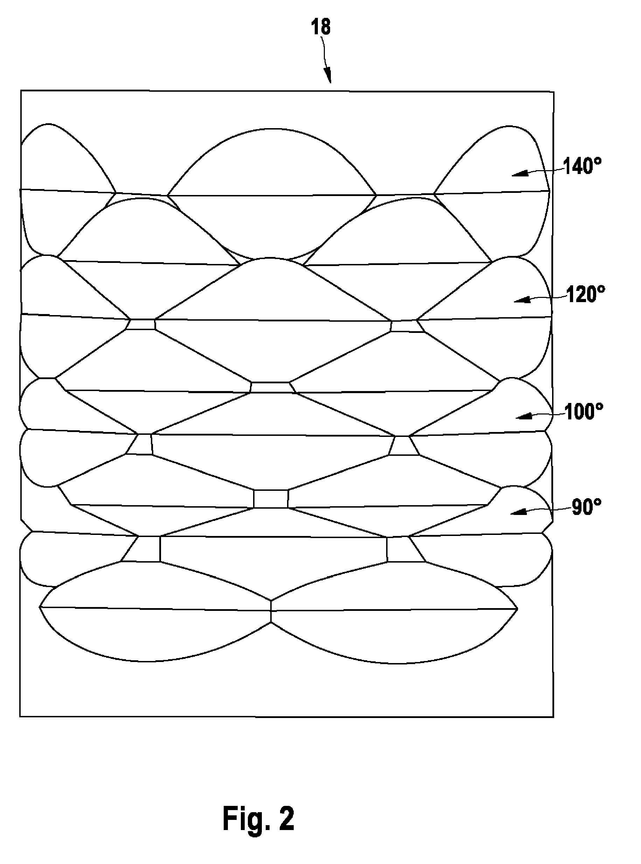

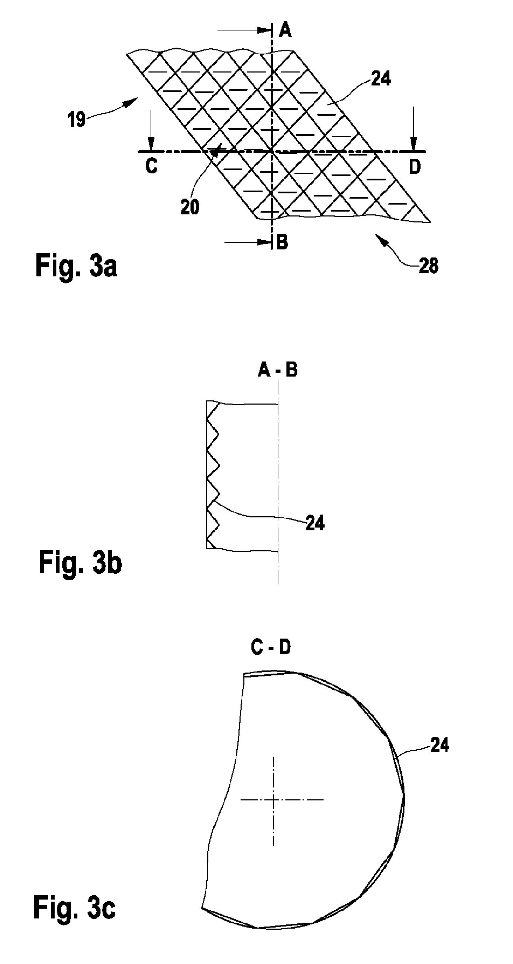

Erfindungsgemäß kommt ein Schutzschichtsystem 17 aus einem Elastomer bzw. einem elektrisch nichtleitenden Öl und einer in Fig. 2 bzw. in Fig. 3a bis 3c dargestellten Metallhülse 18, 24 zum Einsatz. Die Metallhülse 18, 24 erzielt die nötige Dichtwirkung gegenüber dem mindestens einen zwischen Aktorfuß 05 und Aktorkopf 04 angeordneten Piezoaktor 16 und ist an beiden Enden mit Aktorfuß 05 und Aktorkopf 04 hochdruckdicht verbunden. Der durch Aktorfuß 05 und Aktorkopf 04 begrenzte Raum zwischen Metallhülse 18, 24 und dem mindestens einen Piezoaktor 16 ist vollständig mit dem Elastomer bzw. dem elektrisch nichtleitendem Öl befüllt.

Die an beiden Enden mit Aktorfuß 05 und Aktorkopf 04 hochdruckdicht verbundene Metallhülse 18, 24 ist vorzugsweise mit dem Aktorfuß 05 und dem Aktorkopf 04 hochdruckdicht verschweißt.

Die Metallhülse 18, 24 weist vorzugsweise eine in axialer Richtung wegausgleichende Geometrie 19 auf und nimmt dadurch die Hubbewegungen aus der Funktion des Piezoaktormoduls über ihre wegausgleichende Geometrie 19 in axialer Richtung auf. Gleichzeitig wird über die Geometrie 19 die Wärmedehnung des Elastomers und der anderen Bauteile ausgeglichen. Auf diese Weise wird eine zu hohe radiale Dehnung der bzw. mögliche Überbeanspruchung der Metallhülse 18, 24 verhindert.

Da die Metallhülse 18, 24 ohne Lufteinschlüsse befüllt ist, werden Druckschwankungen im Piezoinjektor 01 durch die Metallhülse 18, 24 so kompensiert, dass die Metallhülse 18, 24 jederzeit druckausgeglichen ist und sich auch bei radialer Verformung keine unzulässige Materialbelastung ergibt.

Das Elastomer dient der Wärmeabfuhr von dem mindestens einen Piezoaktor 16 zur Metallhülse 18, 24, zur elektrischen Isolation und als Stützelement gegenüber der Metallhülse 18, 24 unter dem herrschenden, das Piezoaktormodul bzw. den Piezoaktor und die Metallhülse 18, 24 unmittelbar umgebenden Systemdruck von bis zu 2500 bar.

Die Metallhülse 18, 24 weist vorzugsweise eine Oberflächenstruktur 20 auf, welche dauerhaft eine gleichzeitige Verformung in axialer wie auch in radialer Richtung ohne plastische Deformation ermöglicht.

Die Metallhülse 18, 24 weist vorzugsweise eine Oberflächenstruktur 20 in Form einer Wabenstruktur 21, 28 auf. Die Metallhülse 18, 24 mit Wabenstruktur 21, 28 stellt den nötigen Hub- und Temperaturausgleich in einem Bereich von vorzugsweise mindestens - 40°C bis mindestens + 160°C am Piezoaktormodul 03 bzw. Piezoaktor 16 sicher. Dabei wird im Vergleich zum Stand der Technik die Permeation von Feuchtigkeit, wie etwa Diesel, Wasser, RME und sonstigen elektrisch leitenden Substanzen auf ein Minimum verringert bzw. unterbunden.

Die Wabenstruktur 21 der in Fig. 2 dargestellten Metallhülse 18 kann dabei unregelmäßig geformt sein. Die einzelnen Flächen 23 der Waben 22 weisen gegenüber senkrecht zur Längsachse der Metallhülse 18 verlaufenden Ebenen identische, wie auch unterschiedliche, durch unterschiedliche Winkelangaben von 90°, 100°, 120° und 140° angedeutete Neigungen bzw. Ausrichtungen und damit unterschiedliche Abmessungen sowohl in radialer als auch in axialer Richtung auf. Die entsprechende Ausführung hängt dabei von der jeweiligen Last ab.

Besonders bevorzugt ist die Metallhülse 24 mit einer in Fig. 3 dargestellten regelmäßigen Wabenstruktur 28 versehen. Sie dient als flexibles Dicht- und Ausgleichelement und schützt den Piezoaktor 16 vor Kraftstoff- und Wassereintritt. Eine Ausrichtung der Dehnung bzw. Dehnfähigkeit der Metallhülse 24 ist dabei vor allem in axialer Richtung als Hauptdehnungsrichtung vorgesehen.

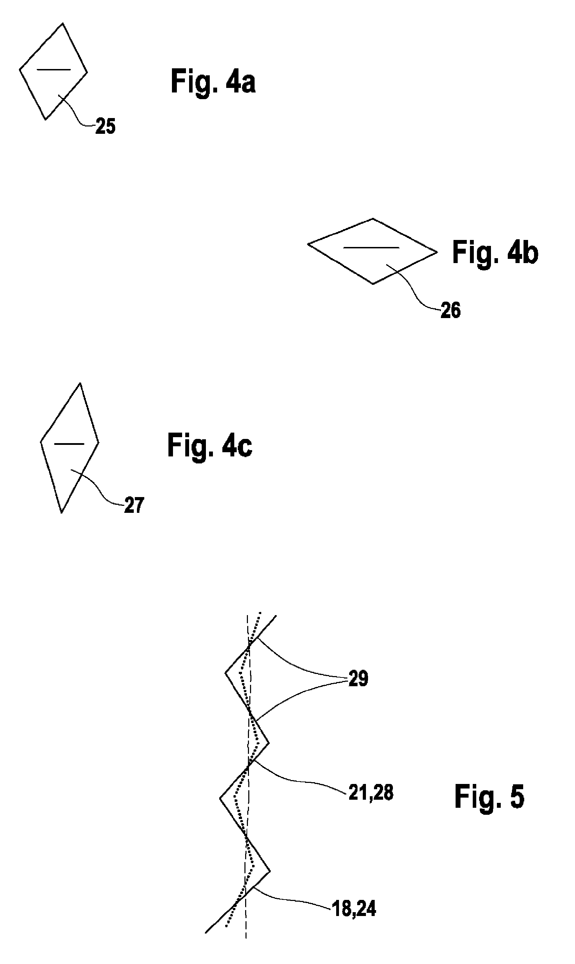

Zur Ausrichtung der Dehnung bzw. Dehnfähigkeit der Metallhülse 18, 24 können unterschiedliche, in Fig. 4a bis 4c dargestellte Wabenformen verwendet werden. Eine in Fig. 4a dargestellte Wabe 25 weist beispielsweise eine neutrale, das heißt in Bezug auf axiale und radiale Dehnung ausgeglichene Wabenform auf. Eine in Fig. 4 b dargestellte Wabe 26 weist beispielsweise eine axiale, das heißt in Bezug auf axiale und radiale Dehnung eher axiale Dehnungen unterstützende Wabenform auf. Dies ist unter anderem dadurch bedingt, dass durch die kürzere Ausbildung der axialen Länge der Wabe 26 auf einem Abschnitt der Metallhülse 18, 24 mit konstanter Länge mehr Waben 26 in axialer Richtung angeordnet sind, als beispielsweise neutrale Waben 25 auf einem Abschnitt gleicher Länge. Eine in Fig. 4c dargestellte Wabe 27 weist beispielsweise eine radiale, das heißt in Bezug auf axiale und radiale Dehnung eher radiale Dehnungen unterstützende Wabenform auf. Dies ist unter anderem dadurch bedingt, dass durch die kürzere Ausbildung der radialen Länge der Wabe 26 auf dem Umfang der Metallhülse 18, 24 mehr Waben 27 angeordnet sind, als beispielsweise neutrale Waben 25.

Dies wird durch die in Fig. 5 schematisch dargestellte Funktionsweise einer mit einer Wabenstruktur 21, 28 versehenen Metallhülse 18, 24 deutlich, da sich die Funktion der Wabenstruktur 21, 28 durch eine Anordnung mehrerer in Reihe geschalteter Kniehebel 29 erklären lässt.

Die vorzugsweise in ihrer Wandstärke sehr dünn gehaltene Metallhülse 18 nimmt durch ihre konstruktive Auslegung mit einer Wabenstruktur 20, 21 die Hubbewegungen aus der Funktionsvorgabe auf. Gleichzeitig kann die vorzugsweise regelmäßige Wabenstruktur 21 zumindest in einem begrenzten Maß auch beispielsweise sich aus der Wärmeausdehnung der von der Metallhülse 18 umhüllten Bauteile ergebende Radialdehnungen aufnehmen.

Wichtig ist hervorzuheben, dass Kern und Vorteil der Erfindung der Schutz der Metallhülse 18 vor Überbeanspruchung durch das Ausgleichen der Volumenänderungen des Elastomers und der benachbarten Bauteile, hervorgerufen durch Druck- und Temperatureinfluss, bei gleichzeitiger Gewährleistung der Hubbewegung des Piezoaktormoduls 03 bzw. Piezoaktors 16 ist. Ein wesentliches, mit der Erfindung erreichtes Ziel ist, dass die Metallhülse 18 in ihrer Form und Geometrie keine unzulässige Belastung und undefinierte Verformung erfährt.

Die Erfindung erreicht einen kostengünstigen, einfachen und dauerhaften Schutz von beispielsweise zur direkten Düsennadelsteuerung eingesetzten Piezoaktoren 16 unter eingeschränkten Bauraumbedingungen bzw. Platzverhältnissen. Gleichzeitig werden unzulässige Belastungen und Verformungen der Metallhülse 18 unterbunden, welche aus Druck, Temperatur und Volumenänderungen der von der Metallhülse 18 umhüllten Bauteile bzw. der Bestandteile des Piezoaktormoduls 03 hervorgehen. Zusätzlich werden die Belastungen auf den durch das erfindungsgemäße Schutzschichtsystem 17 geschützten Piezoaktor 16 bezüglich Kraft- und Hubverlust so klein wie möglich gehalten.

Die Werkstoffpaarungen von Metallhülse 18, Aktorfuß 05 und Aktorkopf 04 sind in Festigkeit und Wärmeausdehnungskoeffizienten vorteilhafterweise so gewählt, dass keine zusätzlichen Temperaturbelastungen aus diesen Bauteilen aufaddiert werden.

Wichtig ist hervorzuheben, dass die Auslegung eines Schutzschichtsystems 17 unter erfindungsgemäßer Integration von Temperaturausgleich und Funktionsbewegung einen erheblichen Gewinn an Bauraum nach sich zieht.

## Patentansprüche

1. Piezoaktormodul (03) in einer von einem Medium umströmten Anordnung, bestehend aus einem Aktorfuß (05) und einem Aktorkopf (04) und mindestens einem dazwischen eingefassten Piezoaktor (16), umfassend ein mindestens den Piezoaktor (16) umgebendes Schutzschichtsystem (17) aus einer oder mehreren funktionellen Schichten, **dadurch gekennzeichnet, dass** das Schutzschichtsystem (17) mindestens:
- eine erste Schicht bestehend aus einer den mindestens einen Piezoaktor (16) umgebenden, an ihren beiden Enden mit dem Aktorfuß (05) und dem Aktorkopf (04) hochdruckdicht verbundenen Metallhülse (18, 24), sowie
- eine den durch Aktorfuß (05) und Aktorkopf (04) begrenzten Raum zwischen Metallhülse (18, 24) und dem mindestens einen Piezoaktor (16) vollständig ausfüllende zweite Schicht bestehend aus einem Elastomer und/oder einem elektrisch nichtleitenden Öl aufweist.

2. Piezoaktormodul nach Anspruch 1, **dadurch gekennzeichnet, dass** die an beiden Enden mit Aktorfuß (05) und Aktorkopf (04) hochdruckdicht verbundene Metallhülse (18, 24) mit dem Aktorfuß (05) und dem Aktorkopf (04) hochdruckdicht verschweißt ist.

3. Piezoaktormodul nach Anspruch 1 oder 2, **dadurch gekennzeichnet, dass** die Metallhülse (18, 24) eine in axialer Richtung wegausgleichende Geometrie (19) aufweist.

4. Piezoaktormodul nach Anspruch 1, 2 oder 3, **dadurch gekennzeichnet, dass** die Metallhülse (18, 24) eine Oberflächenstruktur (20) aufweist, welche eine gleichzeitige Verformung in axialer wie auch in radialer Richtung frei von plastischer Deformation ermöglicht.

5. Piezoaktormodul nach einem der vorhergehenden Ansprüche, **dadurch gekennzeichnet, dass** die Metallhülse (18, 24) eine Wabenstruktur (21, 28) aufweist.

6. Piezoaktormodul nach Anspruch 5, **dadurch gekennzeichnet, dass** die Metallhülse (24) eine regelmäßige Wabenstruktur (28) aufweist.

7. Piezoaktormodul nach einem der vorhergehenden Ansprüche, **dadurch gekennzeichnet, dass** die Metallhülse (18, 24) eine sehr dünne Wandstärke aufweist.

8. Piezoaktormodul nach einem der vorhergehenden Ansprüche, **dadurch gekennzeichnet, dass** die Werkstoffpaarungen von Metallhülse (18, 24), Aktorfuß (05) und Aktorkopf (04) in Festigkeit und Wärmeausdehnungskoeffizienten so gewählt sind, dass keine zusätzlichen Temperaturbelastungen aus diesen Bauteilen aufaddiert werden.
